# EUROPEAN PATENT APPLICATION

(11) **EP 2 266 920 A2**
(43) Date of publication of application: **29.12.2010**
(21) Application number: 10166413.4
(22) Date of filing: 17.06.2010
(51) Int. Cl.: B81B 7/00

(54) **Interface lid for hermetic MEMS package**

(30) Priority: 22.06.2009 US 488847
(71) Applicant: Honeywell International Inc., Morristown, NJ 07962 (US)
(72) Inventor: Horning, Robert D., Morristown, NJ 07962-2245 (US); Ridley, Jeff A., Morristown, NJ 07962-2245 (US)
(74) Representative: Buckley, Guy Julian

(57) **Abstract**

A hermetically sealed MEMS device package comprises a MEMS device platform, a hermetic interface chip, and an outer seal ring. The MEMS device platform includes a MEMS device surrounded by a continuous outer boundary wall with a top surface. The hermetic interface chip includes a glass substrate and at least one silicon mesa. The glass substrate includes at least one hole and has a lower surface with an inner portion surrounded by an outer portion. The at least one silicon mesa is bonded to the inner portion of the lower surface of the glass substrate, such that the at least one silicon mesa is aligned with the at least one hole in the glass substrate. The outer seal ring bonds the outer portion of the lower surface of the glass substrate to the top surface of the continuous outer boundary wall of the MEMS device platform.

## Description

### CROSS REFERENCE TO RELATED APPLICATION

This application is related to United States Patent Applications Serial No. 12/247,368 (Attorney Docket No. H0020225) having a title of "SYSTEMS AND METHODS FOR IMPLEMENTING A WAFER-LEVEL HERMETIC INTERFACE CHIP" (also referred to herein as "the '368 Application") filed on October 08, 2008. The '368 Application is hereby incorporated herein by reference.

### BACKGROUND

High-performance microelectromechanical systems ("MEMS") devices, such as MEMS gyros and MEMS accelerometers, are hermetically packaged in a vacuum or gaseous environment. Typically, the high-performance MEMS gyros are packaged in a vacuum and the high-performance MEMS accelerometers are packaged in a gas. For proper operation, both the vacuum atmosphere of high-performance MEMS gyros and the gas atmosphere of the high-performance MEMS accelerometers should be stable over time, such that no gas enters the vacuum or gas atmospheres and no gas exits the gas atmosphere. Hermetically sealing MEMS device packages allows a vacuum or gas atmosphere to remain stable over time. A hermetic seal is an airtight seal. Hermetic sealing and packaging are processes by which a hermetic seal is formed.

Current MEMS gyro and MEMS accelerometer technologies are typically sealed at the package-level. Substrate caps are configured to seal over the top of MEMS devices, creating a hermetic seal. The sealing of each MEMS package at the package-level typically occurs one-at-a time or in relatively small batches. During package-level sealing, the MEMS devices are hermetically packaged after each individual MEMS device is diced apart from other individual MEMS devices fabricated on a substrate wafer. Package-level sealing is accomplished through a number of processes, including silicon-to-glass anodic bonding, silicon-to-silicon fusion bonding, and wafer-to-wafer bonding with various intermediate bonding agents. Package-level sealing can lead to undesirable effects, such as stiction between a MEMS device wafer and substrate components during a bonding process and lower production yield of MEMS devices.

Wafer-level packaging ("WLP") and sealing can be used to mitigate these and other undesirable effects. During wafer-level packaging and sealing, all individual MEMS devices are sealed and packaged at the same time before the individual MEMS packages are diced apart from the substrate wafer. Wafer-level packaging allows for integration of wafer fabrication, packaging (including device interconnection), and testing at the wafer-level. In practice, wafer-level packaging is difficult to implement due to higher non-recurring engineering costs, increased unit production costs, and various technological challenges associated with typical wafer-level packaging techniques. It has been difficult to achieve a hermetic seal for each individual MEMS package using typical wafer-level packaging techniques. It has also been difficult to implement signal leads from inside the hermetically sealed MEMS package to outside the hermetically sealed MEMS package without creating leaks, electrical shorts, or parasitic effects. In addition, it has been difficult to achieve a proper vacuum during sealing and to install a getter for vacuum applications.

### SUMMARY

A hermetic interface chip comprises a glass substrate having at least one hole and at least one silicon mesa bonded to the glass substrate. The glass substrate has a lower surface including a first portion and a second portion. The first portion of the lower surface is configured to bond with a microelectromechanical system device platform. The at least one silicon mesa is bonded to the second portion of the lower surface of the glass substrate. The first portion of the lower surface surrounds the second portion of the lower surface. The at least one silicon mesa is aligned with the at least one hole in the glass substrate.

A hermetically sealed microelectromechanical system device package comprises a microelectromechanical system device platform, a hermetic interface chip, and an outer seal ring. The microelectromechanical system device platform includes a microelectromechanical system device and a continuous outer boundary wall surrounding the microelectromechanical system device. The continuous outer boundary wall has a top surface. The hermetic interface chip includes a glass substrate and at least one silicon mesa. The glass substrate includes at least one hole and has a lower surface with an inner portion surrounded by an outer portion. The at least one silicon mesa is bonded to the inner portion of the lower surface of the glass substrate, such that the at least one silicon mesa is aligned with the at least one hole in the glass substrate. The outer seal ring is disposed between the outer portion of the lower surface of the glass substrate and the top surface of the continuous outer boundary wall of the microelectromechanical system device. The outer seal ring bonds the lower surface of the glass substrate to the top surface of the continuous outer boundary wall.

A method comprises creating a hermetic interface chip by forming at least one hole through a glass substrate having a lower surface, bonding a silicon substrate to the lower surface of the glass substrate, and etching the silicon substrate to create at least one silicon mesa having a base positioned near the at least one hole and an apex positioned opposite the base, wherein the at least one silicon mesa is aligned with the at least one hole in the glass substrate.

The details of various embodiments of the claimed invention are set forth in the accompanying drawings and the description below. Other features and advantages will become apparent from the description, the drawings, and the claims.

### DRAWINGS

FIG. 1 is a side cross-sectional view of one embodiment of a hermetic interface chip.
FIG. 2 is a flow diagram showing one embodiment of a method of fabricating the hermetic interface chip of FIG. 1.
FIG. 3 is a side cross-sectional view of an embodiment of a hermetically sealed MEMS package, including the hermetic interface chip of FIG. 1 interfacing with one embodiments of an example MEMS device platform.
FIG. 4 is a flow diagram showing an example method of hermetically sealing the MEMS device platform of FIG. 3 with the hermetic interface chip of FIGS. 1 and 3.
FIG. 5 is a side cross-sectional view of another embodiment of a hermetically sealed MEMS package, including another hermetic interface chip interfacing with the MEMS device platform of FIG. 3.
FIG. 6 is a side cross-sectional view of another embodiment of a hermetically sealed MEMS package, including another hermetic interface chip interfacing with another MEMS device platform.
FIG. 7 is a top view of the hermetically sealed MEMS package of FIG. 6.
FIG. 8 is a flow diagram showing an example method of creating the hermetically sealed MEMS package of FIGS. 6-7.

Like reference numbers and designations in the various drawings indicate like elements.

### DETAILED DESCRIPTION

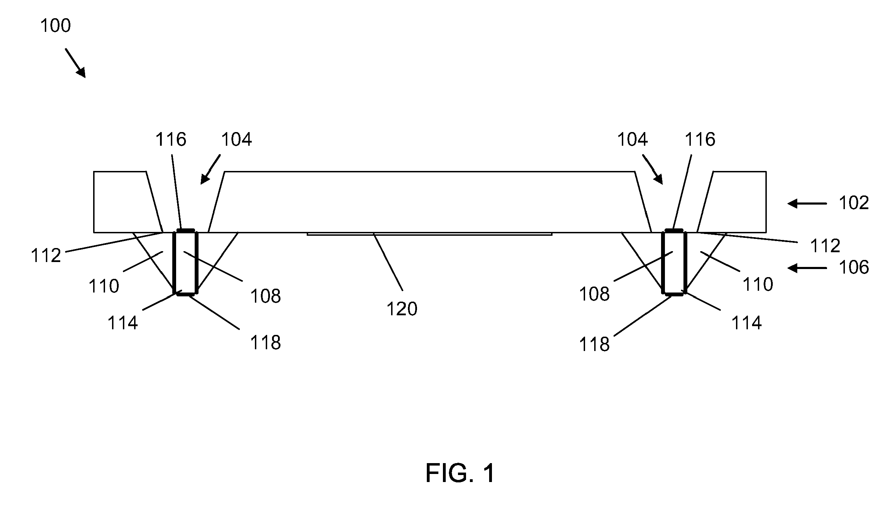

FIG. 1 is a cross-sectional side view of one embodiment of a hermetic interface chip ("HIC") 100. Hermetic interface chips are used in the on-chip, wafer-level hermetic sealing of vacuum or gas enclosures for MEMS devices such as MEMS gyros and MEMS accelerometers. Example hermetic interface chips were discussed in detail in the '368 Application. The '368 Application included discussion of an embodiment made from silicon and an embodiment made from glass. Silicon or glass wafer hermetic interface chips are fabricated for attachment over MEMS gyros or MEMS accelerometers on MEMS device wafers.

A hermetic interface chip designed using silicon is relatively easy to fabricate. The silicon in a hermetic interface chip fabricated from silicon has a different thermal expansion than the glass from which the MEMS gyro or MEMS accelerometer is made. The different thermal expansion between the silicon and glass results in temperature sensitivity in the output of the device. A hermetic interface chip designed using glass has better performance than one designed using silicon, but it is more difficult to fabricate. Because the glass of a hermetic interface chip fabricated with glass has the same thermal expansion as the glass from which the gyro or accelerometer is made, a hermetic interface chip designed using glass has lower temperature sensitivity than one designed using silicon. But, the glass of a hermetic interface chip fabricated with glass is more difficult to fabricate than the silicon of a hermetic interface chip fabricated with silicon.

The hermetic interface chip 100 has a hybrid glass-silicon design that has the performance of a glass hermetic interface chip with the fabrication simplicity and robustness of a silicon hermetic interface chip. The hermetic interface chip 100 includes a glass substrate layer 102 having one or more holes 104. In the particular implementation shown in FIG. 1, the hermetic interface chip 100 includes two holes 104. The holes 104 typically include a plurality of holes arranged in a pattern. The holes 104 are typically ultrasonically drilled, though particular implementations are created in other ways, such as sandblasting, electrical-discharge machining, or laser micromachining.

The hermetic interface chip 100 also includes a silicon substrate layer 106 having one or more feedthrough vias 108. In the particular implementation shown in FIG. 1, the hermetic interface chip 100 includes two feedthrough vias 108. The feedthrough vias 108 are arranged in the same pattern as the holes 104. The feedthrough vias 108 are typically through silicon vias ("TSVs"). A through silicon via is an electrical connection passing completely through a silicon wafer. A through silicon via is typically a vertical connection etched through a silicon wafer and filled with a conductive material such as metal or doped silicon. A through silicon via is typically used as a three dimensional interconnect in the fabrication of three dimensional integrated circuits ("ICs").

In the hermetic interface chip 100, the silicon substrate layer 106 is typically bonded to the glass substrate layer 102, such that the holes 104 align with the feedthrough vias 108. The silicon substrate layer 106 is typically bonded to the glass substrate layer 102 by anodic bonding, though other types of bonding are sometimes used, such as bonding with a glass frit or solder.

The silicon substrate layer 106 is typically etched, creating one or more silicon mesas 110 surrounding the feedthrough vias 108. In the particular implementation shown in FIG. 1, the hermetic interface chip 100 includes two visible silicon mesas 110. In other implementations, greater or fewer silicon mesas 110 are etched from the silicon substrate layer 106. Typically, each of the silicon mesas 110 includes a plurality of embedded feedthrough vias 108. In example embodiments, there might be four silicon mesas 110, each having 5 feedthrough vias 108, such that there are a total of 20 feedthrough vias 108. Other amounts of feedthrough vias 108 and silicon mesas 110 are also appropriate. Each of the feedthrough vias 108 is created such that it is electrically isolated from the other feedthrough vias 108. To create the silicon mesas 110, the silicon substrate layer 106 is patterned and etched, after bonding to the glass substrate 102, so that only the silicon mesas 110 remain. The silicon substrate layer 106 used in the hermetic interface chip 100 shown in FIG. 1 is typically patterned and etched using anisotropic etching, though other embodiments etched with deep reactive ion etching ("DRIE") will be discussed below. During anisotropic etching, an anisotropic etchant is used to etch the silicon, such as potassium hydroxide ("KOH") or ethylenediamine pyrocatechol ("EDP").

Each of the silicon mesas 110 created through anisotropic etching are typically pyramidal in shape, though the silicon mesas 110 sometimes take other shapes. Specifically, each of the silicon mesas 110 typically have a base 112 disposed near the bond between the silicon mesas 110 of the silicon substrate layer 106 and the glass substrate layer 102. Each of the silicon mesas 110 typically have an apex 114, having a smaller area than the base 112, disposed on a side opposite to the base 112. When anisotropic etching is used, each base 112 of each of the silicon mesas 110 is typically larger in area than the bases of the silicon mesas created when deep reactive ion etching is used. (Embodiments using deep reactive ion etching will be discussed below.) Typically, in the hermetic interface chip 100, each of the silicon mesas 110 has a number of feedthrough vias 108 embedded in it, which match a corresponding set of holes 104 in the glass substrate layer 102.

Each of the feedthrough vias 108 has a top side disposed near the base 112 of the silicon mesas 110 and a bottom side disposed near the apex 114 of the silicon mesas 110. Typically, the hermetic interface chip 100 also includes one or more electrical bond pads 116 attached to the top side of each of the feedthrough vias 108. In the particular implementation shown in FIG. 1, the hermetic interface chip 100 includes two electrical bond pads 116. Typically, the hermetic interface chip 100 also includes one or more electrical bond pads 118 attached to the bottom side of each of the feedthrough vias 108. In the particular implementation shown in FIG. 1, the hermetic interface chip 100 includes two electrical bond pads 118. The electrical bond pads 118 are used to connect a MEMS device hermetically sealed by the hermetic interface chip to the feedthrough vias 108, while the electrical bond pads 116 are used to connect the feedthrough vias 108 to devices external to the hermetic seal of the MEMS package.

In implementations requiring a vacuum, at least one getter component 120 is disposed on the underside of the hermetic interface chip, such that it will be inside of the hermetic seal created through hermetic sealing. The getter component 120 is activated during hermetic sealing to create a vacuum. Other elements used during the hermetic sealing, such as solder seal rings and solder balls, are discussed in detail below. These other elements can be applied to either the hermetic interface chip 100 or a MEMS device platform prior to hermetic sealing.

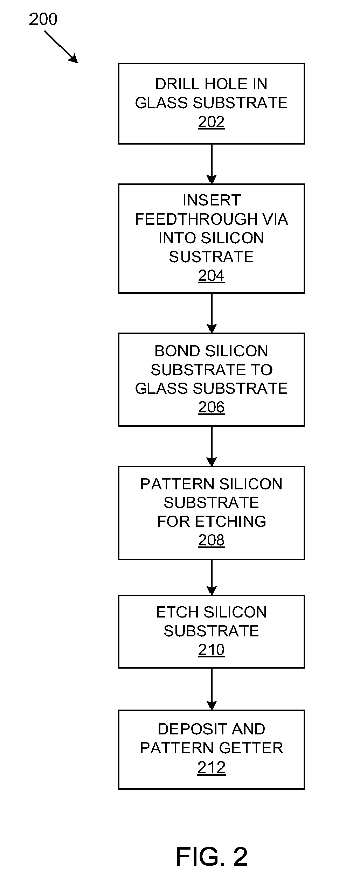

FIG. 2 is a flow diagram showing an example method 200 of fabricating the hermetic interface chip 100. The method 200 begins at block 202, where the holes 104 are drilled through the glass substrate layer 102. The method 200 proceeds to block 204, where the feedthrough vias 108 are created in the silicon substrate layer 106. The method 200 proceeds to block 206, where the silicon substrate layer 106 is bonded to the glass substrate layer 102, such that the holes 104 in the glass substrate layer 102 align with the feedthrough vias 108 of the silicon substrate layer 106. As described above, the bonding of the silicon substrate layer 106 to the glass substrate layer 102 is typically by anodic bonding, though other types of bonding are sometimes used.

The method 200 proceeds to block 208, where the silicon substrate is typically patterned for etching. The method 200 proceeds to block 210, where the silicon substrate is etched, such that only the silicon mesas 110 with the embedded feedthrough vias 108 remain. As described above, the etching is typically anisotropic etching or deep reactive ion etching. Typically, the electrical bond pads 116 and the electrical bond pads 118 are already incorporated into the feedthrough vias 108. In some implementations, the method 200 includes further steps for fabricating or applying the electrical bond pads 116 and the electrical bond pads 118 to the feedthrough vias 108. The method 200 proceeds to block 212, where the getter component 120 is deposited and patterned on the bottom side of the glass substrate layer 102, such that it will be inside the cavity created between the hermetic interface chip 100 and a MEMS device after hermetic sealing. As noted above, the getter component 120 is activated during hermetic sealing to create a vacuum.

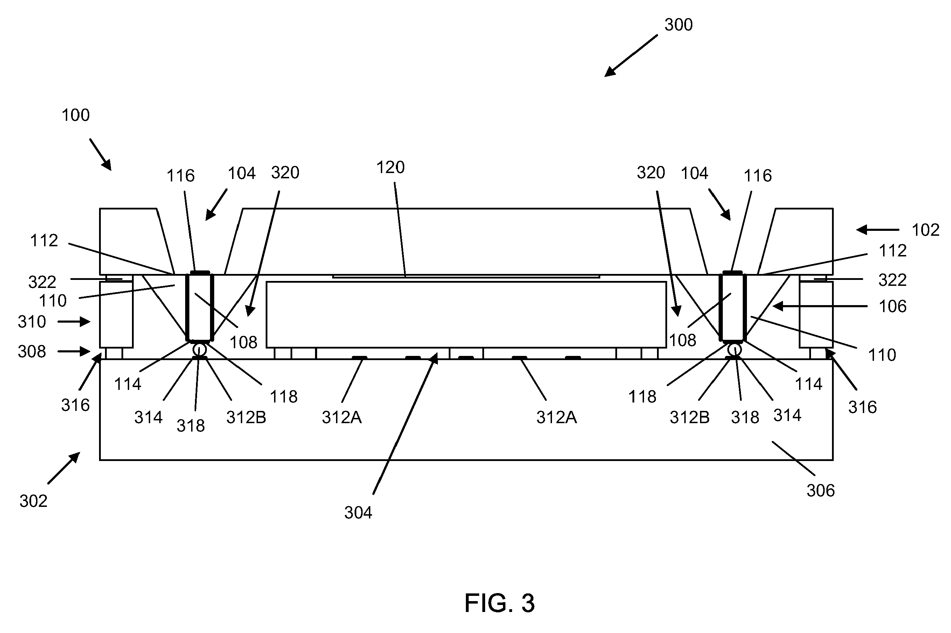

FIG. 3 is a cross-sectional side view of a hermetically sealed MEMS package 300 created when the hermetic interface chip 100 interfaces with a MEMS device platform 302. A MEMS device platform is a wafer that includes a MEMS device, such as a MEMS gyro or MEMS accelerometer. The MEMS device platform 302 typically includes a MEMS device 304, such as a MEMS gyro or a MEMS accelerometer, though it sometimes includes other MEMS devices. The MEMS device platform 302 includes a lower substrate layer 306, a MEMS device layer 308, and an upper substrate layer 310. The MEMS device platform 302 is typically fabricated using methods known in the art for creating MEMS devices, including deposition of individual layers of substrate, patterning of individual layers of substrate, and etching of individual layers of substrate.

In the example shown in FIG. 3, the lower substrate layer 306 is fabricated from glass. The MEMS device layer 308 is typically fabricated from etched silicon. The MEMS device layer 308 is typically patterned, etched and anodically bonded to the lower substrate layer 306. In particular implementations, the MEMS device layer 308 is patterned and etched. In particular implementations, the MEMS device layer 308 is patterned using photolithography and etched using antistrophic or deep reactive ion etching. In some implementations, the MEMS device layer 308 includes multiple layers of silicon patterned and etched in multiple ways.

Typically, the MEMS device 304 is implemented in the MEMS device layer 308 of the MEMS device platform 302. In the MEMS device platform 302 shown in FIG. 3, the MEMS device 304 is shown in the center of the MEMS device layer 308. Typically, some of the MEMS device layer 308 is also used to create one or more electrical leads 312 on the surface of the lower substrate layer 306. In the particular implementation shown in FIG. 3, the MEMS device platform 302 includes several electrical leads 312. These electrical leads 312 are usually fabricated using platinum, though the electrical leads 312 can also be fabricated using gold, aluminum, copper, and polycrystalline silicon. Each of the electrical leads 312 are connected to the MEMS device 304 on a first end 312A and connected to one or more electrical bond pads 314 positioned on the lower substrate layer 306 on a second end 312B. In the particular implementation shown in FIG. 3, the hermetic MEMS device platform 302 includes several electrical bond pads 314. The electrical bond pads 314 are typically fabricated using a gold film deposited on top of platinum, though other conductive materials can also be used, such as aluminum and copper. The electrical leads 312 are used to interface between the MEMS device 304 and devices outside of the hermetically sealed MEMS package 300. In addition, some of the MEMS device layer 308 is used to create a lower portion of an outer boundary wall 316.

The upper substrate layer 310 is typically disposed onto the MEMS device layer 308 and anodically bonded to the MEMS device layer 308. The upper substrate layer 310 is typically fabricated from glass. The glass of the upper substrate layer 310 is typically etched or drilled. Holes are created in the upper substrate layer 310, typically by micro-sandblasting or ultrasonic drilling. Some of the glass of the upper substrate layer 310 is used to create an upper portion of the outer boundary wall 316. In the example implementation shown in FIG. 3, the portions of the MEMS device layer 308 and the upper substrate layer 310 are fabricated so that the outer boundary wall 316 remains surrounding the MEMS device 304 implemented in the MEMS device layer 308. The outer boundary wall 316 completely surrounds the MEMS device 304. In other implementations, other MEMS device platforms similar to the MEMS device platform 302 are fabricated from other materials or fabricated in other ways.

As noted above, the MEMS device 304 is typically electrically coupled to a first end 312A of one of the electrical leads 312 disposed on the lower substrate layer 306. The MEMS device 304 is typically electrically coupled to the first end 312A of one of the electrical leads 312 during the fabrication of the MEMS device layer 308, though it can be electrically coupled in a different manner. Specifically, both the MEMS device 304 and the electrical leads 312 are typically fabricated from the MEMS device layer 308 and are electrically coupled by design during the etching of MEMS device layer 308. The electrical bond pads 118 disposed on the bottom side of the feedthrough vias 108 are typically electrically coupled to the electrical bond pads 314, which are electrically coupled to the second end 312B of the electrical leads 312. The electrical bond pads 118 are typically electrically coupled to the electrical bond pads 314, and thus the second end 312B of the electrical leads 312, using one or more solder balls 318. In the particular implementation shown in FIG. 3, the hermetically sealed MEMS package 300 includes two solder balls 318. Typically, the solder balls 318 are placed on the electrical bond pads 314 at the second end 312B of each of the electrical leads 312 before the hermetic interface chip 100 is positioned on top of the MEMS device platform 302. Subsequently, the hermetic interface chip 100 is positioned on top of the MEMS device platform 302, such that the electrical bond pads 118 align with the solder balls 318 and the electrical bond pads 314 at the second end 312B of the electrical leads 312. Then, the solder balls 318 are reflowed to electrically couple the second end 312B of the electrical leads 312 to the electrical bond pads 118 through the electrical bond pads 314 and the solder balls 318, such that the MEMS device platform 302 is electrically coupled to the bottom side of the feedthrough vias 108.

The hermetic interface chip 100 is typically hermetically sealed to the MEMS device platform 302, sealing the MEMS device 304 inside a cavity 320 created between the hermetic interface chip 100 and the MEMS device platform 302. Typically, an outer seal ring 322 is disposed around the entire top side of the outer boundary wall 316. The outer seal ring 322 is typically formed using a continuous ring of metal solder. Though other materials can be used, sealing with metal solder is preferred because it is a process that allows relatively large variations in positioning and spacing, while still creating a proper hermetic seal. In the hermetically sealed MEMS package 300, the solder is first disposed on top of the outer boundary wall, the hermetic interface chip 100 is next positioned on top of the MEMS device platform 302, and the metal solder of the outer seal ring 322 (in addition to any other solder in the hermetically sealed MEMS package 300, including the solder balls 318 discussed above) is reflowed so that the outer seal ring 322 connects the bottom side of the glass substrate layer 102 of the hermetic interface chip 100 to the top surface of the outer boundary wall 316.

After hermetic sealing by the hermetic interface chip 100 and reflowing the solder balls 318, the MEMS device 304 is electrically coupled to the electrical bond pads 116 positioned external to the hermetic seal on the top side of the hermetic interface chip 100, such that electricity, including electrical signals, can travel to and from the hermetically sealed MEMS device 304 inside the hermetically sealed MEMS package 300 to devices outside of the hermetic seal. To electrically and communicatively couple the MEMS device 304 inside the hermetically sealed MEMS package 300 to another device outside of the hermetically sealed MEMS package 300, the other device is coupled to the electrical bond pads 116 on the exterior of the hermetically sealed MEMS package 300. Electrical shorts and parasitics related to other methods and devices for hermetically sealing MEMS devices are avoided in the hermetically sealed MEMS package 300 because the feedthrough vias 108 in the silicon mesas 110 allows signals to pass from inside the hermetically sealed cavity 320 without going through the outer seal ring 322.

In implementations requiring a vacuum, the getter component 120 is disposed on the hermetic interface chip 100 inside the cavity 320. Once the outer seal ring 322 hermetically seals around all openings between the hermetic interface chip 100 and the outer boundary wall 316 of the MEMS device platform 302, the getter component 120 is activated to create a vacuum inside the cavity 320. Because much of the area inside the cavity 320 remains unused, the getter component 120 is deposited anywhere within the hermetically sealed cavity 320, thereby providing sufficient gettering capacity and a stable vacuum seal. The getter component 120 is unnecessary when the cavity 320 inside of the hermetic seal is a gaseous atmosphere.

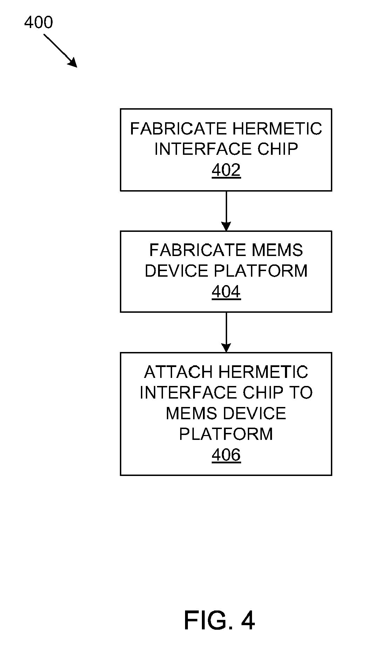

FIG. 4 is a flow diagram showing an example method 400 of hermetically sealing the MEMS device platform 302 using the hermetic interface chip 100. The method 400 begins at block 402, where the hermetic interface chip 100 is fabricated according to the method 200 described above. The method proceeds to block 404, where the MEMS device platform 302 is fabricated according to conventional methods. In other example implementations, the order of block 402 and the block 404 are reversed, such that the MEMS device platform 302 is fabricated before the hermetic interface chip 100 is fabricated according to the method 200 described above. In other example implementations, the actions of block 402 and block 404 occur in parallel. Finally, the method 400 proceeds to block 406, where the hermetic interface chip 100 is attached to the MEMS device platform 302, creating an air tight seal between the MEMS device platform 302 and the hermetic interface chip 100. Typically, in cases requiring a vacuum, the getter component 120 is activated inside the sealed cavity 320, removing any excess gas from the sealed cavity 320.

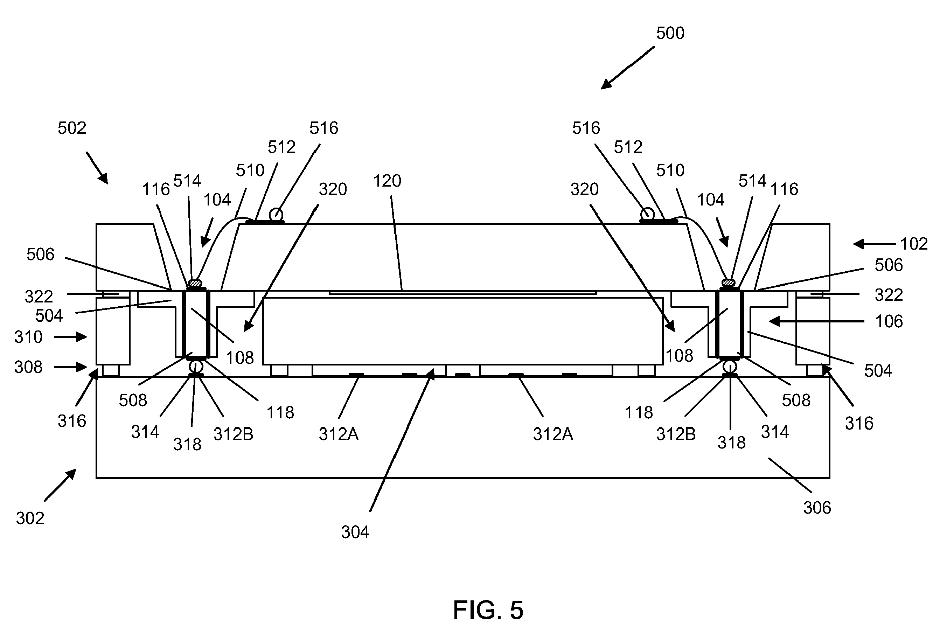

FIG. 5 is a cross-sectional side view of another embodiment of a hermetically sealed MEMS package 500 created when a hermetic interface chip 502 interfaces with the MEMS device platform 302. The hermetic interface chip 502 is distinguished from the hermetic interface chip 100 by the method in which the silicon substrate layer 106 is etched. The silicon substrate layer 106 is etched in the hermetic interface chip 502 using deep reactive ion etching, instead of the anisotropic etching used in the hermetic interface chip 100. The hermetic interface chip 502 includes one or more silicon mesas 504 similar to the silicon mesas 110, each of the silicon mesas 504 having a base 506 and an apex 508. In the particular implementation shown in FIG. 5, the hermetic interface chip 502 includes two silicon mesas 504. Each base 506 is similar to each base 112 of the silicon mesas 110. Each apex 508 is similar to each apex 114 of the silicon mesas 110. Deep reactive ion etching allows the creation of silicon mesas with smaller base areas. Because the silicon mesas 504 are etched using deep reactive ion etching, each base 506 of each of the silicon mesas 504 typically has a smaller area than does each base 112 of each of the silicon mesas 110. Also, each base 506 of each of the silicon mesas 504 does not typically have the same pyramidal shape as each of the silicon mesas 110.

The hermetically sealed MEMS package 500 also includes one or more electrical connectors 510 and one or more electrical bond pads 512. In the particular implementation shown in FIG. 1, the hermetic interface chip 100 includes two electrical connectors 510, such as wire bonding capillaries, and two electrical bond pads 512. A first end of each of the electrical connectors 510 is coupled with one of the electrical bond pads 116 and a second end of each of the electrical connectors 510 is coupled with one of the electrical bond pads 512 mounted on top of the hermetic interface chip 100, outside of the holes 104. Typically, the holes 104 need to be between about 300 micrometers and about 500 micrometers wide and about 1500 micrometers long to accommodate the electrical connectors 510. Typically, the first end of the electrical connectors 510 is connected to the electrical bond pads 116 using one or more solder balls 514, though other connections are appropriate. In the particular implementation shown in FIG. 5, the hermetic interface chip 502 includes two solder balls 514. The electrical bond pads 512 are the connection points for external devices to interface with the MEMS device 304 in the hermetically sealed MEMS package 600. External devices are typically connected to the electrical bond pads 512 using one or more solder balls 516, though other connections are appropriate. In the particular implementation shown in FIG. 5, the hermetic interface chip 502 includes two solder balls 516.

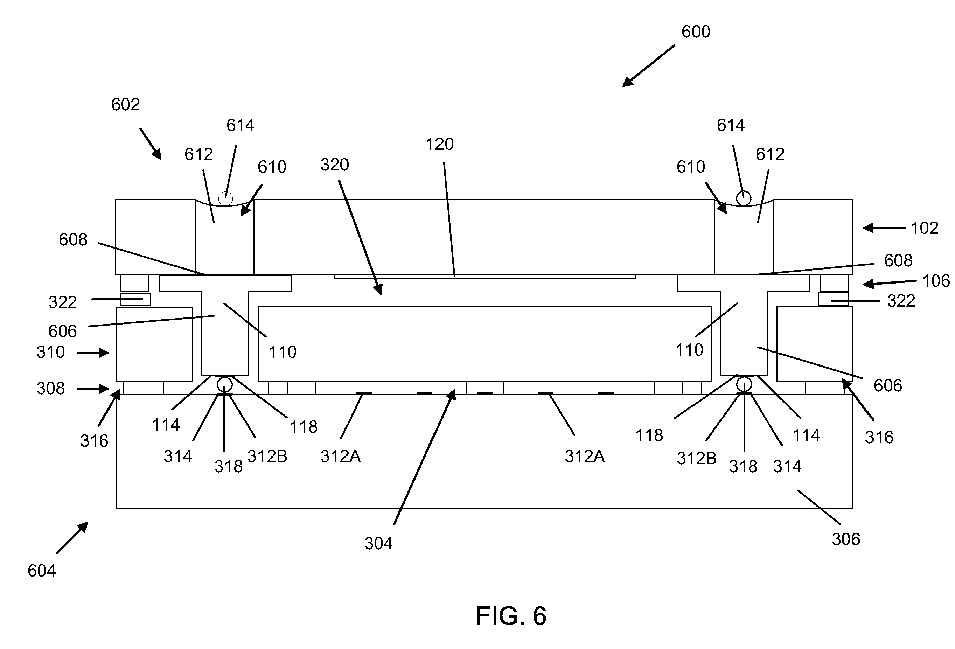

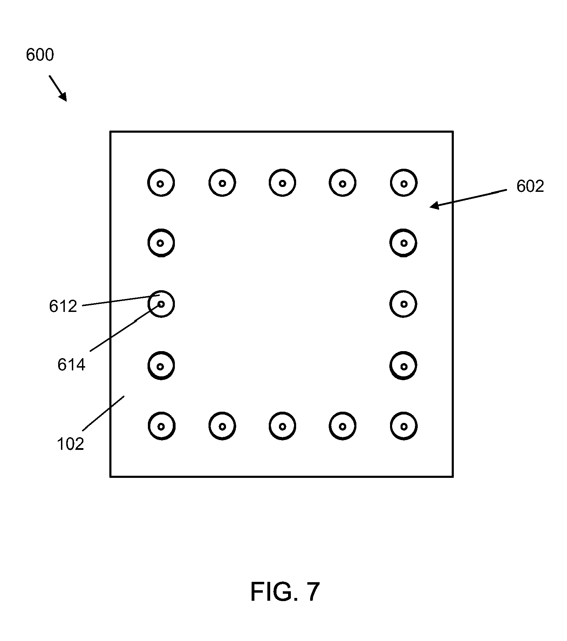

FIG. 6 is a side cross-sectional view of another embodiment of a hermetically sealed MEMS package 600 including a hermetic interface chip 602 interfacing with a MEMS device platform 604. FIG. 7 is a top view of the hermetically sealed MEMS package 600 including the hermetic interface chip 602 interfacing with the MEMS device platform 604. The MEMS device platform 604 includes all the components of the MEMS device platform 302. The difference between the MEMS device platform 604 and the MEMS device platform 302 is that each of the second end 312B of each of the electrical leads 312 disposed on the lower substrate layer 306 are widely separated from each other and distributed around the die in the MEMS device platform 604. (A plurality of each of these second end 312B of each of the electrical leads 312 are typically bunched together under single mesas in the MEMS device platform 302.) The positioning of the widely separated and distributed second end 312B of the electrical leads 312 is visible in FIG. 6.

The hermetic interface chip 602 contains similar elements to the hermetic interface chip 502, with a few notable differences. The hermetic interface chip 602 includes one or more silicon mesas 606, similar to the silicon mesas 504. In the particular implementation shown in FIGS. 6-7, the hermetic interface chip 602 includes sixteen silicon mesas 606. The sixteen silicon mesas 606 of the hermetic interface chip 602 are each electrically isolated from one another and do not include any embedded feedthrough vias 108. Specifically, in the hermetic interface chip 602, each of the silicon mesas 606 are separated from the other silicon mesas 606 and each of the silicon mesas 606 is positioned on the hermetic interface chip 602 such that it aligns with the second end 312B of one of the widely separated and distributed electrical leads 312. Each of the silicon mesas 606 is electrically isolated from the other silicon mesas 606, such that each of the silicon mesas 606 functions as a conductive element between one of the electrical bond pads 118 and one of the electrical bond pads 116. Thus, the feedthrough vias 108 are not needed in the implementation shown in FIGS. 6-7. Each of the silicon mesas 606 of the hermetic interface chip 602 have a base 608 similar to the base 506 of each of the silicon mesas 504 of the hermetic interface chip 502. Because there are no feedthrough vias 108 in the center of each of the silicon mesas 606 and because deep reactive ion etching is used to create the silicon mesas 606, each of the silicon mesas 606 can have a smaller base 608 than the base 506 of each of the silicon mesas 504.

In addition to the other elements described with reference to the hermetic interface chip 502, the hermetic interface chip 602 also includes one or more holes 610 drilled in the glass substrate layer 102, similar to the holes 104 of the hermetic interface chip 100 and the hermetic interface chip 502. In the particular implementation shown in FIG. 6, the hermetic interface chip 602 includes sixteen holes 610 (all of which are visible in FIG. 7, while only two are visible in FIG. 6). Instead of using an electrical connector similar to the electrical connectors 510 to bring the connection up out of each of the holes 610, the hermetic interface chip 602 includes one or more conductive plugs 612. In the particular implementation shown in FIGS. 6-7, the hermetic interface chip 602 includes sixteen conductive plugs 612 (all of which are visible in FIG. 7, while only two are visible in FIG. 6). The conductive plugs 612 are typically made of solder, though the conductive plugs 612 are sometimes made of plated metal or another conductive material. The conductive plugs 612 conduct the electric signals from the silicon mesas 504 up to the top of the glass substrate layer 102. Thus, electrical signals and other forms of electricity can travel between the top of the conductive plugs 612 to the electrical bond pads 118, such that the top of the conductive plug is electrically coupled to the MEMS device 304.

An external device can be coupled with the MEMS device 304 by connection with the top of the conductive plugs 612 using one or more solder balls 614 placed on top of the conductive plugs 612. In the particular implementation shown in FIG. 6, the hermetic interface chip 602 includes two solder balls 614. Use of the conductive plugs 612 enables the holes 610 of the hermetic interface chip 602 to be smaller than the holes 104 of the hermetic interface chip 502. While the holes 104 of the hermetic interface chip 502 are between about 300 micrometers and about 500 micrometers wide and about 1500 micrometers long in order to accommodate the electrical connectors 510, the holes 610 of the hermetic interface chip 602 does not have to accommodate the electrical connectors 510 and can be smaller. The holes 610 of the hermetic interface chip 602 are typically between about 50 micrometers and about 1000 micrometers, and preferably between about 100 micrometers and about 500 micrometers. In other implementations, the holes 610 of the hermetic interface chip 602 are smaller, while in others the holes 610 are larger. The potentially smaller size of the holes 610 of the hermetic interface chip 602, the potentially smaller size of the silicon mesas 606 without the feedthrough vias 108, and the rearrangement of the second end 312B of the electrical leads 312 enable both the die size and the cost of the hermetically sealed MEMS package 600 to be reduced.

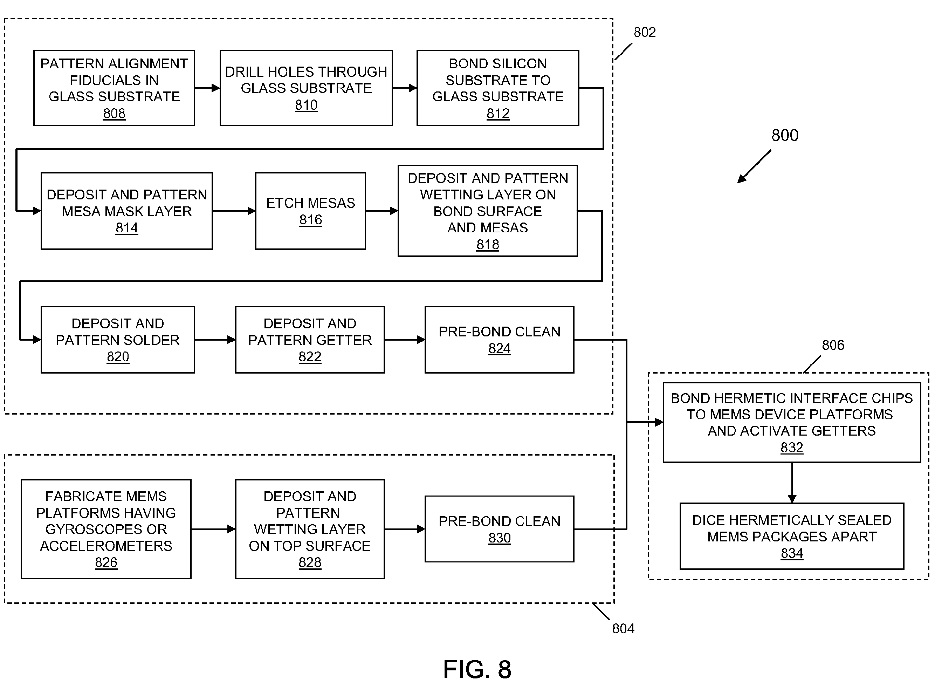

FIG. 8 is a flow diagram showing an example method 800 of creating the hermetically sealed MEMS package 600. The method 800 includes a first sub-method 802 for creating the hermetic interface chip 602, a second sub-method 804 for creating the MEMS device platform 604, and a third sub-method 806 for hermetically sealing the hermetic interface chip 602 on top of the MEMS device platform 604. In some embodiments, sub-method 802 and sub-method 804 occur in parallel, while in other embodiments one of sub-method 802 or sub-method 804 occurs before the other. The sub-method 806 typically occurs after both sub-method 802 and sub-method 804 are completed.

The first sub-method 802 for creating the hermetic interface chip 602 begins at block 808, where alignment fiducials are patterned in the glass substrate layer 102. The sub-method 802 proceeds to block 810, where the holes 610 are drilled through the glass substrate layer 102. The sub-method 802 proceeds to block 812, where the top of the silicon substrate layer 106 is bonded to the bottom of the glass substrate layer 102. This typically occurs by anodic bonding, though other types of bonding are sometimes used.

The sub-method 802 proceeds to block 814, where a mesa mask layer is deposited and patterned onto the bottom of the silicon substrate layer 106. The sub-method 804 proceeds to block 816, where the silicon mesas 606 are etched from the silicon substrate layer 106. The silicon mesas 606 are typically etched using a deep reactive ion etching process. The sub-method 802 proceeds to block 818, where a wetting layer is deposited and patterned on the bond surface and on the silicon mesas 606. Typically, the wetting layer is a patterned metal film that solder will wet to, created with gold and other metals.

The sub-method 802 proceeds to block 820, where the solder is deposited and patterned. Typically, the solder is deposited and patterned on the hermetic interface chip 604, such that the solder outer seal ring 322, the solder balls 318, and the solder balls 614 are positioned as described with reference to FIGS. 6-7. Specifically, the solder outer seal ring 322 is deposited and patterned on the underside of the glass substrate layer 102, the solder balls 318 is deposited and patterned on the electrical bond pads 118, and the solder balls 614 is deposited and patterned on top of the conductive plugs 612. (In other embodiments, the solder outer seal ring 322 and the solder balls 318 are deposited and patterned on the MEMS device platform 604, instead of the hermetic interface chip 602.) The sub-method 802 proceeds to block 822, where the getter component 120 is deposited and patterned on the bottom side of the glass substrate layer 102, such that it will be inside the cavity 320 created between the hermetic interface chip 602 and the MEMS device platform 604. The sub-method 802 proceeds to block 824, where the hermetic interface chip 602 is cleaned prior to bonding.

The sub-method 804 begins at block 826, where the MEMS device platform 604 is fabricated. As described above, the MEMS device platform 604 typically includes a MEMS device 304, such as a MEMS gyro or a MEMS accelerometer. The MEMS device platform 604 is fabricated as described above or in another method used by those skilled in the fabrication of MEMS devices. The sub-method 804 proceeds to block 828, where a wetting layer is deposited and patterned on the top surface of the MEMS device platform 604. The sub-method 804 proceeds to block 830, where the MEMS device platform 604 is cleaned prior to bonding.

The sub-method 806 begins at block 832 after the sub-method 802 and the sub-method 804 are complete. At block 832, the hermetic interface chip 602 is bonded to the MEMS device platform 604 creating the hermetically sealed MEMS package 600 and the getter component 120 is typically activated. The bonding typically includes positioning the hermetic interface chip 602 onto the MEMS device platform 604 and subsequently reflowing the solder outer seal ring 322, the solder balls 318, and the solder balls 614. In other implementations, other methods are used to bond the hermetic interface chip 602 to the MEMS device platform 604. In implementations not requiring a vacuum, the getter component 120 is either not present or not activated. The bonding at block 832 typically occurs at the wafer-level. Thus, a plurality of the hermetic interface chip 602 is created on a single wafer and a plurality of the MEMS device platform 604 is created on a single wafer. During the bonding at block 832, the plurality of the hermetic interface chip 602 is hermetically sealed onto the plurality of the MEMS device platform 604, creating a plurality of the hermetically sealed MEMS package 600.

The sub-method 806 proceeds to block 834, where the hermetically sealed MEMS package 600 is diced apart from other hermetically sealed MEMS packages in the plurality of the hermetically sealed MEMS package 600.

A number of embodiments of the invention defined by the following claims have been described. Nevertheless, it will be understood that various modifications to the described embodiments may be made without departing from the spirit and scope of the claimed invention. Accordingly, other embodiments are within the scope of the following claims.

## Claims

1. A hermetic interface chip (100) comprising:
a glass substrate (102) having at least one hole (104), the glass substrate having a lower surface, wherein a first portion of the lower surface is configured to bond with a microelectromechanical system device platform (302);
at least one silicon mesa (110) bonded to a second portion of the lower surface of the glass substrate, wherein:
the first portion of the lower surface surrounds the second portion of the lower surface; and
the at least one silicon mesa is aligned with the at least one hole in the glass substrate.

2. The hermetic interface chip of claim 1, wherein the at least one silicon mesa is etched from a silicon substrate (106) bonded to the glass substrate.

3. The hermetic interface chip of claim 1, wherein the at least one silicon mesa includes:
a base (112) positioned near the at least one hole;
an apex (114) positioned opposite the base; and
at least one feedthrough via (108) having a top end near the base and a bottom end near the apex, wherein the at least one feedthrough via is electrically conductive between the top end and the bottom end.

4. A hermetically sealed microelectromechanical system device package (300) comprising:
a microelectromechanical system device platform (302) including:
a microelectromechanical system device (304); and
a continuous outer boundary wall (316) surrounding the microelectromechanical system device, the continuous outer boundary wall having a top surface; and
a hermetic interface chip (100) including:
a glass substrate (102) having at least one hole (104), the glass substrate having a lower surface with an inner portion and an outer portion, wherein the outer portion surrounds the inner portion; and
at least one silicon mesa (110) bonded to the inner portion of the lower surface of the glass substrate, such that the least one silicon mesa is aligned with the at least one hole in the glass substrate; and
an outer seal ring (322) disposed between the outer portion of the lower surface of the glass substrate and the top surface of the continuous outer boundary wall of the microelectromechanical system device, the outer seal ring bonding the lower surface of the glass substrate to the top surface of the continuous outer boundary wall.

5. The device package of claim 4, wherein a hermetically sealed cavity (320) is formed between the microelectromechanical system device platform and the hermetic interface chip.

6. The device package of claim 4, wherein:
the at least one silicon mesa includes:
a base (112) positioned near the at least one hole;
an apex (114) positioned opposite the base; and
an electrically conductive feedthrough via (108) having a top end and a bottom end opposite the top end, the electrically conductive feedthrough via running vertically from the bottom end at the base of the silicon mesa to the top end at the apex of the silicon mesa; and
the microelectromechanical system device is electrically coupled with the bottom end of the electrically conductive feedthrough via, such that the microelectromechanical system device is electrically coupled with the top end of the electrically conductive feedthrough via.

7. A method (800) comprising:
creating a hermetic interface chip (200, 802) by:
forming at least one hole through a glass substrate having a lower surface (202, 810);
bonding a silicon substrate to the lower surface of the glass substrate (206, 812);
and
etching the silicon substrate to create at least one silicon mesa (201, 816) having a base positioned near the at least one hole and an apex positioned opposite the base, wherein the at least one silicon mesa is aligned with the at least one hole in the glass substrate.

8. The method of claim 7, wherein the creating a hermetic interface chip further comprises creating at least one feedthrough via in the silicon substrate (204), such that the at least one feedthrough via is embedded within the at least one silicon mesa and aligned with the at least one hole.

9. The method of claim 7, the method further comprising:
creating a microelectromechanical system device platform (804) having a microelectromechanical system device and an outer boundary wall surrounding the microelectromechanical system device; and
bonding the lower surface of the glass substrate of the hermetic interface chip to a top surface of the outer boundary wall (832).

10. The method of claim 9, wherein creating the hermetic interface chip further comprises creating at least one feedthrough via in the silicon substrate (204) having a top end near the base and a bottom end near the apex, wherein the at least one feedthrough via is electrically conductive between the top end and the bottom end.
